# EUROPEAN PATENT APPLICATION

(11) **EP 2 472 597 A1**
(43) Date of publication of application: **04.07.2012**
(21) Application number: 10811712.8
(22) Date of filing: 16.08.2010
(51) Int. Cl.: H01L 31/042

(54) **SOLAR CELL STRING AND SOLAR CELL MODULE USING SAME**

(30) Priority: 27.08.2009 JP 2009196293
(71) Applicant: Sanyo Electric Co., Ltd., Osaka 570-8677 (JP)
(72) Inventor: HASHIMOTO Haruhisa, Moriguchi-shi Osaka 570-8677 (JP)
(74) Representative: Calderbank, Thomas Roger
(86) International application number: PCT/JP2010/063809
(87) International publication number: WO 2011/024662

(57) **Abstract**

Disclosed are: a solar cell string which is capable of assuring reliability in high-temperature retention test and high-temperature cycles; and a solar cell module. Specifically disclosed is a solar cell string which comprises a plurality of solar cells (10), and a wiring member (11) that electrically connects the plurality of solar cells (10) with each other. A resin adhesive (12) is disposed between the wiring member (11) and main surfaces of the solar cells (10) . The wiring member (11) is obtained by forming a conductor layer (11b), which uses tin or an alloy material containing tin, around a low resistance body (11a) and covering the surface of the conductor layer (11b) with a metal thin film (11c) that uses silver or a silver alloy.

## Description

### TECHNICAL FIELD

The invention relates a solar cell string and a solar cell module using the same.

### BACKGROUND ART

A solar cell converts clean and unlimitedly-supplied sunlight directly into electricity and is therefore expected to be a new energy source.

The output power of a single solar cell is generally about a couple of watts. Thus, when solar cells are used as a power source of a house, a building, or the like, a solar cell module is used in which multiple solar cells are connected to increase the output power of the solar cell module. The solar cell module has a structure in which the solar cells are connected in series and/or in parallel by wiring members electrically connected to electrodes on front and rear surfaces of the solar cells.

In the manufacturing process of the solar cell module, solder is conventionally used to connect the electrodes of the solar cells to the wiring members. Solder is widely used since it is low in cost, has high versatility, and is excellent in connection reliability such as conductivity and fixing strength.

On the other hand, in a solar cell module, a method of connecting wiring members without using solder is also used to reduce effects of heat during the connection of wiring members. For example, there is known a method of connecting solar cells to wiring members by using an adhesive film including a resin adhesive (for example, see Patent Document 1).

The connection of wiring with an adhesive film is performed as follows. First, adhesive films are attached onto electrodes of the solar cells. Then, the wiring members are placed on the adhesive films and the resultant solar cells are heated with the wiring members pressed toward the solar cells. The wiring members are thereby connected to the electrodes of the solar cells by using the resin adhesive.

Such a technique can reduce the effects of temperature change on the solar cells during thermo-compression bonding of wiring members, compared to the case of soldering the wiring members.

In this connection, a type of wiring member used for the connection of wiring with an adhesive film is one including a thin-plate-shaped low-resistance member made of copper or the like and having its surface plated with a conductor such as a eutectic solder. Then, the wiring member is connected with part of an electrode buried into the conductor on the wiring member.

### PRIOR ART DOCUMENT

Patent Document 1: Japanese Patent Application Publication No. 2005-101519

### SUMMARY OF THE INVENTION

### PROBLEMS TO BE SOLVED BY THE INVENTION

A high-temperature storage test at 170°C is performed on the aforementioned conventional solar cell module in which the wiring members plated with the eutectic solder are connected to electrodes by using a resin adhesive. As a result of this test, it is found that the adhesion strength of the wiring members is reduced in some cases. The reason of this is not sure but it is conceivable that the adhesion force is reduced by flow of solder which is caused by heat.

Meanwhile, the solar cell modules are also required to be reliable in a high-temperature cycle.

An object of the invention is to provide a solar cell string and a solar cell module which are improved in reliability in the high-temperature storage test and the high-temperature cycle.

### MEANS FOR SOLVING THE PROBLEMS

A solar cell string of the invention is a solar cell string comprising solar cells and a wiring member electrically connecting the solar cells to each other. The solar cell string is **characterized in that** each of the solar cells include a photoelectric conversion body configured to generate carriers by receiving light and an electrode formed on a principle surface of the photoelectric conversion body and configured to collect the carriers, a resin adhesive is disposed between the wiring member and the principle surface of each of the solar cells, and, in the wiring member, a conductor layer made of tin or a tin-containing alloy material is formed on a periphery of a low-resistance body and a surface of the conductor layer is covered with a metal thin film made of silver or a silver alloy.

### EFFECTS OF THE INVENTION

The invention uses such a wiring member that the conductor layer including tin or a tin-containing alloy material is formed on the periphery of the low-resistance body and the surface of the conductor layer is covered with the metal thin film including silver or a silver alloy. This makes it possible to secure reliability in a high temperature storage test and a high-temperature cycle and to improve reliability of the solar cell module.

### BRIEF DESCRIPTION OF THE DRAWINGS

[Fig. 1] Fig. 1 is an enlarged cross-sectional side view of a solar cell module of an embodiment.
[Fig. 2] Fig. 2 is a plan view of a solar cell of the embodiment.
[Fig. 3] Fig. 3 is a cross-sectional view taken along the line A-A of Fig. 2.
[Fig. 4] Fig. 4 is a plan view showing a state where wiring members are disposed respectively on bus bar electrodes shown in Fig. 2.
[Fig. 5] Fig. 5 is an enlarged cross-sectional view of a cut section taken along the line B-B of Fig. 4.
[Fig. 6] Fig. 6 is an enlarged cross-sectional view showing the wiring member used in the embodiment.
[Fig. 7] Fig. 7 is an enlarged cross-sectional view showing a modification of the wiring member used in the embodiment.
[Fig. 8] Fig. 8 is an enlarged cross-sectional view showing another modification of the wiring member used in the embodiment.
[Fig. 9] Fig. 9 is an enlarged cross-sectional view showing yet another modification of the wiring member used in the embodiment.
[Fig. 10] Fig. 10 is a schematic diagram showing a peel strength test.
[Fig. 11] Fig. 11 is a schematic diagram showing a method of manufacturing a solar cell string of the invention.

### EMBODIMENTS OF THE INVENTION

Embodiments of the invention are described in detail with reference to the drawings. The same or corresponding parts are denoted by the same reference numerals and descriptions thereof are omitted to avoid overlapping descriptions. Note that the drawings are schematic and proportions of dimensions and the like are different from actual ones. Accordingly, specific dimensions and the like should be determined in consideration of the descriptions below. Moreover, parts where relations and proportions of the dimensions are different among the drawings are included as a matter of course.

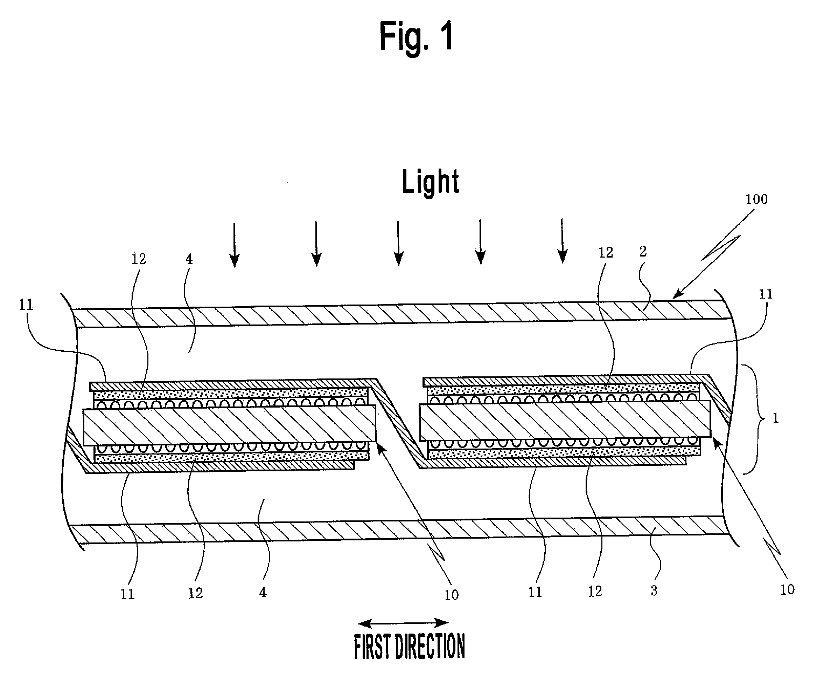

A schematic configuration of solar cell module 100 of an embodiment of the invention is described with reference to Fig. 1. Fig. 1 is an enlarged cross-sectional side view of solar cell module 100 of the embodiment.

Solar cell module 100 includes solar cell string 1, light-receiving surface member 2, rear surface member 3, and sealing material 4. Solar cell module 100 is formed by sealing solar cell string 1 between light-receiving surface member 2 and rear surface member 3.

Solar cell string 1 includes solar cells 10, wiring members 11, and resin adhesive 12. Solar cell string 1 is formed by connecting solar cells 10 arranged in a first direction to one another with wiring members 11.

Each of solar cells 10 has a light-receiving surface on which the sunlight falls and a rear surface which is provided on the opposite side of the light-receiving surface. The light-receiving surface and the rear surface are principal surfaces of solar cell 10. Collection electrodes are formed on the light-receiving surface and the rear surface of solar cell 10. A configuration of solar cell 10 is to be described later.

Each of wiring members 11 is connected to the electrode formed on the light-receiving surface of one solar cell 10 and to the electrode formed on the rear surface of another solar cell 10 adjacent to the one solar cell. Solar cells 10, 10 adjacent to each other are thereby electrically connected to each other. As to be described later, wiring member 11 includes: a thin-plate shaped low-resistance body (copper or the like); a conductor (an eutectic solder or the like) formed on a surface of the low resistance body by plating; and a metal thin film covering a surface of the conductor and including silver or a silver alloy.

Resin adhesive 12 is disposed between each of wiring members 11 and correspond one of solar cells 10. In other words, wiring member 11 is connected to solar cell 10 via resin adhesive 12. Resin adhesive 12 preferably cures at a temperature equal to or lower than the melting point of the eutectic solder, i.e. at a temperature of about 200C°or below. For example, a conductive adhesive film is used as resin adhesive 12. Conductive adhesive film 12 is formed to include at least a resin adhesive component and conductive particles dispersed in the resin adhesive component. The resin adhesive component in which the conductive particles are dispersed is provided on a base film made of polyimide or the like. Resin adhesive component 5b is made of a composition including a thermosetting setting resin. For example, an epoxy resin, a phenoxy resin, an acrylic resin, a polyimide resin, a polyamide resin, and a polycarbonate resin can be used. These thermosetting resins are used alone or in combination of two or more thermosetting resins. One or more thermosetting resins selected from the group consisting of the epoxy resin, the phenoxy resin, and the acrylic resin are preferably used.

For example, metal particles such as gold particles, silver particles, copper particles and nickel particles are used as the conductive particles. Alternatively, conductive particles, such as gold-plated particles, copper-plated particles, and nickel-plated particles, which are each formed by covering a surface of a conductive or insulative core particle with a conductive layer such as a metal layer, are used as the conductive particles.

Light-receiving surface member 2 is disposed on a light-receiving-surface side of sealing material 4 and protects a front surface of solar cell module 100. A translucent glass with water-blocking properties, a translucent plastic, or the like can be used as light-receiving surface member 2.

Rear surface member 3 is disposed on a rear-surface side of sealing material 4 and protects a back surface of solar cell module 100. A resin film of PET (Polyethylene Terephthalate) or the like, a stacked film having such a structure that Al foil is interposed between resin films, or the like can be used as rear surface member 3.

Sealing material 4 seals solar cell string 1 at a position between light-receiving surface member 2 and rear surface member 3. A translucent resin such as EVA, EEA, PVB, silicon, urethane, acryl, or epoxy can be used as sealing material 4.

Note that an Al (aluminum) frame (not illustrated) can be attached to an outer periphery of solar cell module 100 having the aforementioned configuration.

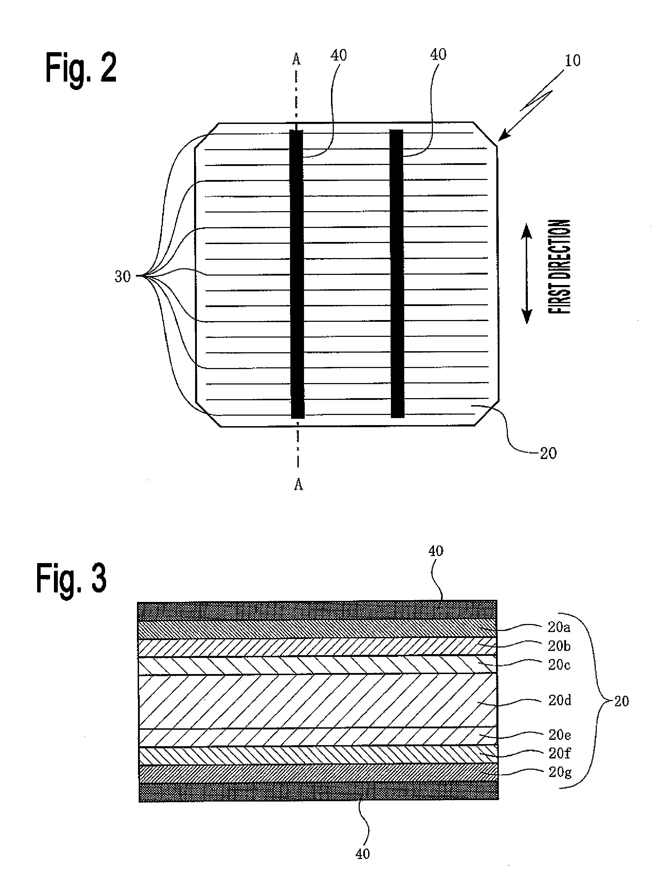

Next, a configuration of solar cell 10 is described with reference to Fig. 2. Fig. 2 is a plan view of solar cell 10.

As shown in Fig. 2, solar cell 10 includes photoelectric conversion body 20, finger electrodes 30, and bus bar electrodes 40.

Photoelectric conversion body 20 generates carriers by receiving the sunlight. Here, the carries refer to photogenerated carriers generated when the sunlight is absorbed by photoelectric conversion body 20. Photoelectric conversion body 20 includes therein an n-type region and a p-type region and a semiconductor junction is formed at an interface between the n-type region and the p-type region. Photoelectric conversion body 20 can be formed by using a semiconductor substrate made of a semiconductor material including a crystalline semiconductor material such as a single crystal Si and a polycrystalline Si, a compound semiconductor material such as GaAs and InP, and the like. A solar cell as follows is used as photoelectric conversion body 20. For example, in the solar cell, an intrinsic amorphous silicon layer is interposed between a single crystal silicon and an amorphous silicon layer, which respectively have conductivity types opposite to each other, to reduce defects in the interface therebetween and improve characteristics of heterojunction interface.

Finger electrodes 30 are electrodes configured to collect the carriers from photoelectric conversion body 20. As shown in Fig. 2, finger electrodes 30 are formed linearly along a second direction which is almost perpendicular to the first direction. Multiple finger electrodes 30 are formed across almost the entire light-receiving surface of photoelectric conversion body 20. Finger electrodes 30 are formed by using a resin-type conductive paste in which a resin material is used as a binder and conductive particles such as silver particles are used as a filler. Incidentally, as shown in Fig. 1, the finger electrodes are formed similarly on the light-receiving surface and the rear surface of photoelectric conversion body 20.

Bus bar electrodes 40 are electrodes configured to collect carriers from finger electrodes 30. As shown in Fig. 2, bus bar electrodes 40 are formed along the first direction to intersect finger electrodes 30. As similar to finger electrodes 30, bus bar electrodes 40 can be formed by using a resin-type conductive paste in which a resin material is used as a binder and conductive particles such as silver particles are used as a filler. Incidentally, as shown in Fig. 1, the bus bar electrodes are formed also on the light-receiving surface of photoelectric conversion body 20.

The number of bus bar electrodes 40 can be set to an appropriate number in consideration of the size of photoelectric conversion body 20 and the like. Solar cell 10 of the embodiment includes two bus bar electrodes 40.

Next, a case where photoelectric conversion body 20 has a so-called HIT structure is described as an example of the configuration of solar cell 10 with reference to Fig. 3. Fig. 3 is a cross-sectional view taken along the line A-A of Fig. 2.

As shown in Fig. 3, photoelectric conversion body 20 includes translucent conductive film 20a, p-type amorphous silicon layer 20b, i-type amorphous silicon layer 20c, n-type single silicon substrate 20d, i-type amorphous silicon layer 20e, n-type amorphous silicon layer 20f, and translucent conductive film 20g.

p-type amorphous silicon layer 20b is formed on the light-receiving-surface side of n-type single silicon substrate 20d with i-type amorphous silicon layer 20c in between. Translucent conductive film 20a is formed on the light-receiving-surface side of p-type amorphous silicon layer 20b. Meanwhile, n-type amorphous silicon layer 20f is formed on the rear-surface side of n-type single crystal silicon substrate 20d with i-type amorphous silicon layer 20e in between. Translucent conductive film 20g is formed on the rear-surface side of n-type amorphous silicon layer 20f.

Finger electrodes 30 and bus bar electrodes 40 are formed on each of translucent conductive film 20a on the light-receiving-surface side and translucent conductive film 20g on the rear-surface side.

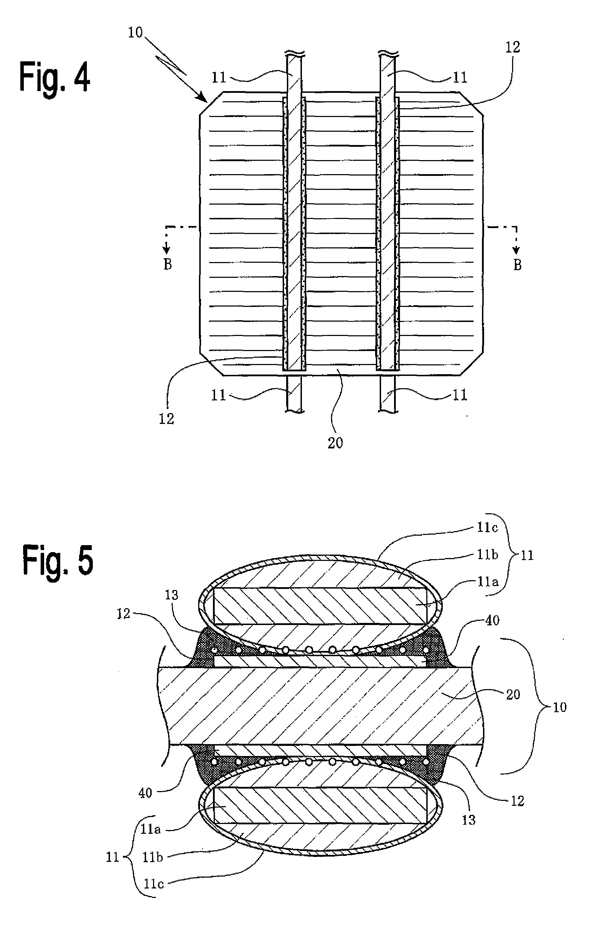

Next, a structure of solar cell string 1 is described with reference to Figs. 4 and 5. Fig. 4 is a view showing a state where wiring members 11 are disposed respectively on bus bar electrodes 40 shown in Fig. 2. Fig. 5 is an enlarged cross-sectional view of a cut section taken along the line B-B of Fig. 4.

As shown in Fig. 4, resin adhesive 12 is disposed on each of bus bar electrodes 40 formed linearly along the first direction. The width of resin adhesive 12 is larger than the width of bus bar electrode 40.

Moreover, wiring members 11 are disposed on resin adhesive 12 along bus bar electrodes 40, respectively. In other words, wiring members 11 are disposed along the first direction on the primary surface of solar cell 10. The width of wiring member 11 is almost the same as the width of bus bar electrode 40.

Bus bar electrodes 40, resin adhesive 12, and wiring members 11 are sequentially disposed on photoelectric conversion body, 20 as described above. Wiring members 11 and bus bar electrodes 40 are electrically connected to each other, respectively.

As shown in Fig. 5, wiring members 11 each includes: copper foil 11a being a low-resistance body and having a thickness of 200 µm and a width of 1mm; conductor 11b provided on a periphery of copper foil 11a and made of tin or a tin-containing alloy; and metal thin film 11c covering a periphery of conductor 11b and made of silver or a silver alloy.

Tin, SnAgCu, SnPb, SnCuNi or the like is used for conductor 11b. In the embodiment, a SnAgCu solder is provided on the periphery of copper foil 11a. Conductor 11b has a thickness of 40 µm at a center portion and the thickness thereof becomes smaller from the center portion toward end portions. Metal thin film 11c is provided by plating the periphery of conductor 11b with silver to a thickness of 1 µm.

Resin adhesive 12 has a thickness of 30 µm before contact bonding and bus bar electrode 40 has a thickness of 50 µm and a width of 1 mm. Incidentally, the substrate of solar cell 10 has a thickness of 200 µm.

As described above, the thickness of conductor 11b becomes smaller toward the end portions in a direction almost perpendicular to the primarily surface of solar cell 10. Accordingly, in a cut section almost perpendicular to the first direction, an outer periphery of wiring member 11 is formed to have a shape protruding toward solar cell 10. As shown in Fig. 5, wiring members 11 respectively on the light-receiving-surface side and the rear-surface side have a similar outer shape.

Resin adhesive 12 is disposed between each wiring member 11 and solar cell 10. Resin adhesive 12 includes particles 13 being conductive. As shown in Fig. 5, particles 13 includes particles 13 embedded in metal thin film 11c and conductor 11b, particles 13 interposed among metal thin film 11c, conductor 11b, and bus bar electrode 40, and particles 13 buried in resin adhesive 12.

Wiring member 11 and bus bar electrode 40 are electrically connected to each other by particles 13 embedded in metal thin film 11c and conductor 11b and particles 13 interposed among metal thin film 11c, conductor 11b, and bus bar electrode 40.

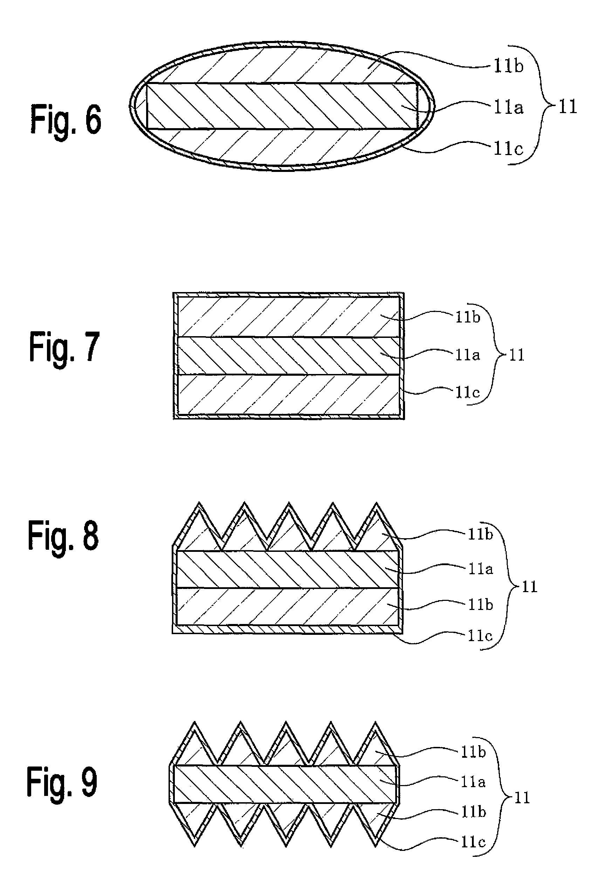

Next, a configuration of wiring member 11 used in the invention is further described with reference to Fig. 6.

Fig. 6 is a view in which the SnAgCu solder as conductor 11b is provided on the periphery of copper foil 11a made of a rectangular copper wire and metal thin film 11c is provided by plating the periphery of conductor 11b with silver.

Such a wiring member 11 is formed as follows. A rectangular copper wire having a thickness of 200 µm and a width of 1 mm is prepared and the SnAgCu solder is provided on the rectangular copper wire to have a thickness of 1 µm to 100 µm, preferably about 40 µm, by dip soldering. The solder composition of the dip soldering is set to Sn 96.5wt%, Ag 3wt%, Cu 0.5wt% in standard concentration. Conductor 11b made of the SnAgCu solder is provided by dip soldering the rectangular copper wire at a withdrawal speed of 1 m/second. Then, Ni plating as an underlying layer of silver plating is provided on a surface of the SnAgCu solder by electroplating to have a thickness of 0.5 µm. The.Ni plating is performed with a temperature and a pH respectively set to 60°C and 4, by using a plating bath having a composition of 330g/liter of nickel nitrate (NiSO₄·6H₂O), 45g/liter of nickel chloride (NiCl₂·6H₂O), and boric acid (H₃BO₃) .

Then, sliver plating is performed to a thickness of 0.1 µm to 10 µm, preferably about 1.0 µm and metal thin film 11c is thereby formed. An ammoniacal solution of silver nitrate including aldehyde, glucose, Rochelle salt, and the like as a reducer is used as a plating bath.

Note that when a copper plating (formed to 0.5 µm by electroplating) is formed on the Ni plating by using a copper sulfate aqueous solution, the sliver plating to be formed on the copper plating can be formed better.

By using wiring member 11 formed as described above, reliability in a high-temperature storage test and in a high-temperature cycle can be secured. Conductor 11b made of the aforementioned solder may be made of a metal having a Vickers hardness smaller than 25 Hv or any one of SnAgCu, SnPb, and the like. Moreover, a sliver plating portion may be made of a silver-containing alloy.

Next, a solar cell using the wiring member of the invention and a solar cell using a conventional wiring member are prepared to perform reliability test and results thereof are shown.

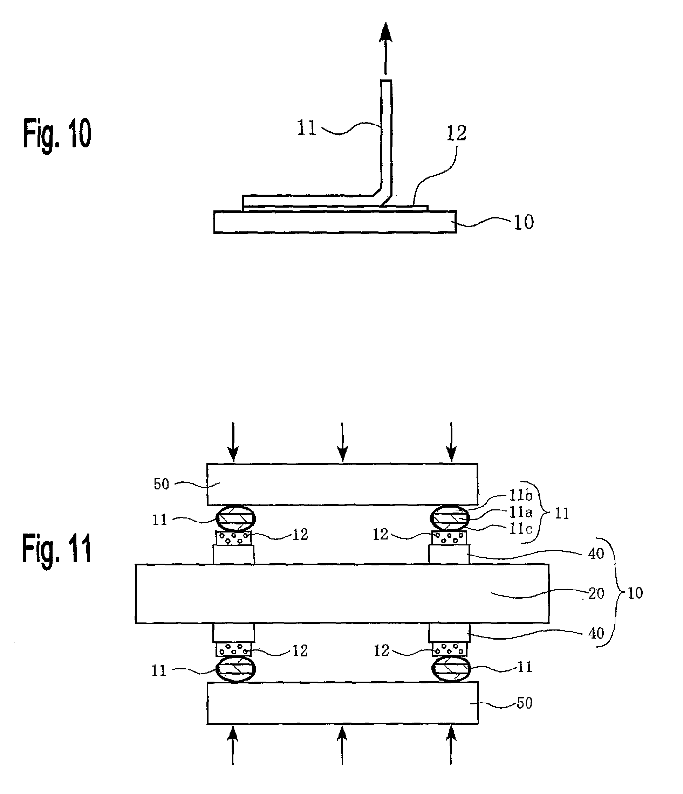

In the high-temperature storage test, solar cell 10 to which wiring member 11 is connected is stored at 170°C for 1000 hours and the strength thereof is then measured to be compared with the initial strength. The measurement is performed as follows. As shown in Fig. 10, wiring member 11 is adhered to bus bar electrode 40 on solar cell 10 by using resin adhesive 12 and a peel strength test of pulling wiring member 11 is performed. The strength is a peak value at a moment of peeling.

The prepared samples include: a conventional example using a wiring member in which conductor 11b made of a solder is provided around a copper foil having the same width of 1 mm and the same thickness of 200 µm; the embodiment of the invention using a wiring member which is provided with metal thin film 11c by plating the surface of conductor 11b with 1.0 µm of sliver; and a reference example using a wiring member which is provided with sliver plating of 1.0 µm directly on the periphery of the copper foil. The peel strength test is performed by using these samples in such a way that, as shown in Fig. 10, wiring member 11 is pulled in the direction of the arrow in the drawing. The results of the test are shown in Table 1.

**[Table 1]**

| Tab process | Initial strength (g) | Strength after test [g] | Ratio to initial value |
|---|---|---|---|
| Solder (Conventional example) | 172.144 | 20.2 | 11.7% |
| Ag plating on solder surface (Embodiment) | 145.85 | 85.2 | 58.4% |
| No solder, Ag Plating (Reference example) | 221.556 | 132.5 | 59.8% |

As is apparent from Table 1, the strength after the test is 11.7% of the initial value in the sample using the conventional wiring member in which only the solder is provided, and the strength of the wiring member is drastically reduced. On the other hand, the embodiment of the invention has a strength equal to 58.4% of the initial value and the reference example has a strength equal to 59.8% of the initial value. It can be understood from this that the degree of deterioration is improved compared to the conventional example.

Next, for each of the samples described above, wiring members 11 are connected to the front and rear of single solar cell 10 by using resin adhesive 12. Then, the solar cell is sealed between a glass member on a front surface and a rear surface member by using a sealing material to form a module. Thereafter, the sample is subjected to the high-temperature cycle test as follows. The sample is heated at a temperature of 120°C for 90 minutes and thereafter cooled to -40°C in 90 minutes. Subsequently, the sample is maintained at -40 °C for 90 minutes and thereafter heated to 120°C in 90 minutes. Table 2 shows results of comparison between the maximum output power value (Pmax) after 200 cycles of this test and the initial value.

**[Table 2]**

| Tab type | Ratio of Pmax to initial value |
|---|---|
| Solder (Conventional example) | 98.50% |
| Silver plating on solder (Embodiment) | 98.70% |
| No Solder, silver plating (Reference example) | 96.60% |

It can be found from Table 2 that the embodiment of the invention has the smallest degree of deterioration with respect to the initial value and achieves a value equal to 98.70% of the initial value.

Accordingly, it can be found from Tables 1, 2 that a wiring member which satisfies both tests is the one of the embodiment of the invention.

Next, modifications of the wiring member used in the invention are described with reference to Figs. 7 to 9.

In an embodiment shown in Fig. 7, a SnAgCu solder is provided as conductors 11b on a periphery of copper foil 11a made of a rectangular copper wire. Conductors 11b are each formed to have a rectangular cross section and are provided with metal thin film 11c by plating flat peripheries of conductors 11b made of the solder with silver.

In an embodiment shown in Fig. 8, conductor 11b made of a solder which is on a side to face resin adhesive 12 is formed to be uneven and then metal thin film 11c is formed by plating conductor 11b with silver. Specifically, as shown in Fig. 8, an uneven portion including mountain portions and valley portions is provided on a side close to resin adhesive 12. The height of the peak of the uneven portion is, for example, 40 µm and a pitch between a protruding portion and another protruding portion is about 1/2 to 1/6 the width of wiring member. In the embodiment, the pitch is set to 0.2 mm. An anchor effect to resin adhesive 12 is expected by forming the uneven portion as describe above and the adhesive strength is thereby expected to be increased.

In an embodiment shown in Fig. 9, uneven portions are provided in portions of solder located on both surfaces of copper foil 11a, respectively. The embodiment is the same as the embodiment shown in Fig. 8 except that unevenness is provided not only on the side closer to the resin adhesive but also on the opposite side.

Next, a method of manufacturing solar cell module 100 of an embodiment is described.

First, n-type single crystal silicon substrate 20d of 100 mm square is subjected to anisotropic etching by using an alkaline aqueous solution and minor unevenness is thereby formed on a light receiving surface of n-type single crystal silicon substrate 20d. Further, the light-receiving surface of n-type single crystal silicon substrate 20d is cleaned to remove impurities.

Next, i-type amorphous silicon layer 20c and p-type amorphous silicon layer 20b are sequentially stacked on the light-receiving-surface side of n-type single crystal silicon substrate 20d by using the CVD (Chemical Vapor Deposition) method. Similarly, i-type amorphous silicon layer 20e and n-type amorphous silicon layer 20f are sequentially stacked on the rear-surface side of n-type single crystal silicon substrate 20d.

Then, translucent conductive film 20a is formed on the light-receiving-surface side of p-type amorphous silicon layer 20b by using the PVD (Physical Vapor Deposition) method. Similarly, translucent conductive film 20g is formed on the rear-surface side of n-type amorphous silicon layer 20f. Photoelectric conversion body 20 is thus produced.

Subsequently, an epoxy-based thermosetting type silver paste is disposed on the light-receiving surface and the rear surface of photoelectric conversion body 20 in a predetermined pattern by using a printing method such as screen printing and offset printing.

The silver paste is heated under a predetermined conduction to vaporize a solvent and is then further heated to be subjected to main drying. Solar cell 10 is thus produced.

Next, as shown in Fig. 11, wiring members 11 are thermo-compression bonded respectively onto bus bar electrodes 40 through resin adhesive 12 including particles 13. Wiring members 11 and solar cell 10 are thereby mechanically and electrically connected together. Specifically, first, resin adhesive 12 and wiring members 11 are sequentially disposed on bus bar electrodes 40 formed on the light-receiving surface and the rear surface of photoelectric conversion body 20. Then, wiring members 11 are pressed toward solar cell 10 for about 15 seconds by heater block 50 heated to about 20°C. As a result; particles 13 are embedded in conductors 11b and are also interposed between conductors 11b and bus bar electrodes 40.

Particles 13 are embedded into the conductors by pressing wiring members 11 to solar cell 10.

Solar cell string 1 is thus formed.

Then, a EVA (sealing material 4) sheet, solar cell string 1, another EVA (sealing material 4) sheet, and a PET sheet (rear surface member 3) are sequentially stacked on a glass substrate (light-receiving surface member 2) to form a stacked body.

Subsequently, the stacked body is temporally compression-bonded by subjecting the stacked body to thermo-compression bonding in a vacuum atmosphere. Thereafter, EVA is completely cured by heating under a predetermined condition. Solar cell module 100 is thus manufactured.

Incidentally, a terminal box, Al frame, and the like can be attached to solar cell module 100.

In each of the embodiments described above, the solar cell including bus bar electrodes 40 with the same width as that of wiring member 11 is described as solar cell 10. However, it is possible to use a solar cell including no bus bar electrodes 40 and a solar cell including bus bar electrodes 40 with a width wider than that of finger electrode 30 but narrower than that of wiring member 11.

Moreover, in the embodiments described above, the conductive resin adhesive including conductive particles is used as the resin adhesive. However, it is possible to use a resin adhesive including no conductive particles. When the resin adhesive including no conductive particles is used, the electrical connection is achieved by bringing a portion of each electrode in direct contact with the surface of a corresponding wiring member. In this case, the wiring member and the electrode are preferably connected to each other with the portion of the electrode buried into the conductor of the wiring member.

It should be understood that the embodiments disclosed herein are exemplary in all points and does not limit the invention. The scope of the invention is defined not by the descriptions of the embodiments but by claims and it is intended that the scope of the invention includes equivalents of claims and all modifications within the scope of claims.

### EXPLANATION OF THE REFERENCE NUMERALS

- 1: solar cell string
- 2: light-receiving surface member
- 3: rear surface member
- 4: sealing material
- 10: solar cell
- 11: wiring member
- 12: resin adhesive
- 30: finger electrode
- 40: bus bar electrode

## Claims

1. A solar cell string comprising:
solar cells; and
a wiring member electrically connecting the solar cells to each other,
wherein each of the solar cells includes a photoelectric conversion body configured to generate carriers by receiving light and an electrode formed on a principle surface of the photoelectric conversion body and configured to collect the carriers,
a resin adhesive is disposed between the wiring member and the principle surface of each of the solar cells, and
in the wiring member, a conductor layer including tin or a tin-containing alloy material is formed on a periphery of a low-resistance body and a surface of the conductor layer is covered with a metal thin film including silver or a silver alloy.

2. The string of claim 1, wherein the conductor layer is formed to have an uneven shape at least on a side close to the resin adhesive.

3. A solar cell module comprising:
a front surface member;
a rear surface member;
solar cells disposed between the front surface member and the rear surface member and electrically connected to each other by a wiring member;
a sealing material disposed between the front surface member and the rear surface member and sealing the solar cells,
wherein the solar cells each comprise:
a photoelectric conversion body configured to generate carriers by receiving light; and
an electrode formed on a principle surface of the photoelectric conversion body and configured to collect the carriers,
wherein a resin adhesive is disposed between the wiring member and the principle surface of each of the solar cells,
wherein, in the wiring member, a conductor layer made of tin or a tin-containing alloy material is formed on a periphery of a low-resistance body and a surface of the conductor layer is covered with a metal thin film made of silver or a silver alloy.

4. The module of claim 3, wherein the conductor layer is formed to have an uneven shape at least on a side close to the resin adhesive.

5. The module of claim 3, wherein the resin adhesive includes conductive particles.

6. The module of claim 3, wherein
each of the electrodes includes finger electrodes configured to collect carriers from a corresponding one of the photoelectric conversion bodies, and
the wiring member and the electrodes are configured such that part of the finger electrodes is buried in the wiring member.
